Europäisches Patentamt

European Patent Office

Office européen des brevets

(11) Publication number: **0 136 421**
**B1**

# (12) EUROPEAN PATENT SPECIFICATION

(45) Date of publication of patent specification: **27.12.90**

(21) Application number: **84108095.5**

(22) Date of filing: **11.07.84**

(51) Int. Cl.⁵: **G 03 F 7/075,** G 03 F 7/20, G 03 F 7/36

(54) Microlithographic process.

(30) Priority: **06.09.83 US 529458**

(43) Date of publication of application:
**10.04.85 Bulletin 85/15**

(45) Publication of the grant of the patent:
**27.12.90 Bulletin 90/52**

(84) Designated Contracting States:
**DE FR GB**

(56) References cited:
**EP-A-0 064 101**
**US-A-3 113 896**
**US-A-4 348 473**

**PATENTS ABSTRACTS OF JAPAN, vol. 5, no. 179 (E-82)851r, 17th November 1981; & JP-A-56 104 437 (HITACHI SEISAKUSHO K.K.) 20-08-1981**

**CHEMICAL PROCESSING, vol. 14, no. 8, August 1968, pages 18,19, Business Press, London, GB; "Photodeposition of polymers"**

(73) Proprietor: **International Business Machines Corporation**
**Old Orchard Road**
**Armonk, N.Y. 10504 (US)**

(72) Inventor: **Hiraoka, Hiroyuki**
**18635 Montewood Drive**
**Saratoga California 95070 (US)**

(74) Representative: **Atchley, Martin John Waldegrave**
**IBM United Kingdom Limited Intellectual Property Department Hursley Park**
**Winchester Hampshire SO21 2JN (GB)**

# Description

This invention relates to a microlithographic process.

Ion beam lithographic processes involve ion beam exposure of polymer films in order to reduce oxygen plasma etch rates of the films, and then dry development by oxygen plasma. In the original work of Kuwano and his co-workers, 20 KeV accelerated focused gallium ion beams were used to reduce oxygen plasma etch rates of exposed areas (see H. Kuwano, K. Yoshida and S. Yamazaki, Japanese J. Appl. Physics, 19 (No. 10) L615 (1980)). Wolf and his co-workers have been successful in obtaining sub-micron poly(methyl methacrylate) patterns using 40 KeV Si$^+$ ions by flood exposure through a self-supporting mask (see I. Adesida, J. D. Chinn, L. Rathbun and E. D. Wolf, J. Vac. Sci. Technol., 21(2), July/Aug. pp 666-671 (1982)). In these references, either specially designed ion beam guns or ion implantation systems are required. By implanting metallic ions like Si$^+$, Ga$^+$, the oxygen plasma etch rates of the resist films are reduced, thereby causing differentiation of the etch rates between exposed and unexposed areas, and resulting in dry development of polymer patterns.

G. Taylor and his co-workers used polymer films uniformly blended with monomer organosilicon for a study of plasma-developed x-ray resists (see G. N. Taylor, T. M. Wolf and J. M. Moran, J. Vac. Aci. Technolo., 19(4) Nov./Dec. 872 (1981)).

S. Harroti has reported post-grafting of trimethylvinylsilane onto poly(methyl methacrylate) after electron beam exposure, (see S. Hattori et al, ACS Org. Coating & Plastic Chem. Report No. 33, Sept. 12-17, 1982, Kansas City meeting). Because an electron beam gun cannot operate at pressure as high as $1 \times 10^{-4}$ torr, he had to transfer the exposed wafers to another chamber for the purpose of grafting.

Patents Abstracts of Japan, vol. 5, No. 179 (E-82) (851) discloses a process comprising the steps of introducing a monomer vapour into a closed chamber containing a substrate, and exposing the monomer vapour to a patterned beam of light or other radiation to thereby form a polymer pattern on the surface of the substrate.

The invention seeks to provide an improved microlithographic process.

The invention provides a microlithographic process comprising depositing a pattern-exposed polymer film on a surface of a substrate by a method consisting of confining a monomer vapour in a closed chamber containing the substrate and exposing the monomer vapour to a patterned beam of radiation; the process being characterised by the beam being a beam of ions, by the deposited polymer film being resistance to oxygen plasma, and by the process further comprising providing an oxygen plasma to dry etch surface portions of the substrate not protected by the exposed polymer film.

Any polymerisable organic vapour can be used as the monomer in carrying out the process of the invention. The most preferred monomers are organosilicon compounds such as tetravinyl-silane, and styrene or other phenyl vinyl compounds. Other useful monomers include acrylonitrile, methacrylonitrile, methyl methcacrylate and phenol.

The most preferred ion beam is of hydrogen ions, i.e., protons. Other ion beams, such as He$^+$ and Ar$^+$, can also be used.

The polymer films may be deposited on many different substrates. For example, the substrate may be another polymer, such as poly(methyl methacrylate), or a novolac resin. Of particular interest is the use of a silicon wafer as the substrate. Resist patterns of 0.5 μm thickness with sloped wall profiles (due to a slanted gun position relative to the wafer position) have been obtained directly from styrene vapour. This technique eliminates several of the steps required in conventional lithographic processes, like formulation of resist solutions, spin-coating, prebaking and development. Besides, no problems of adhesion, cracking or abrasion appear. The polymer films thus obtained are exceedingly CF$_4$ plasma and reactive ion etch resistant, which is of advantage in further microcircuit fabrication processes.

Thin polymer films of organometallic compounds, including organosilicons, are deposited on polymer films like PMMA, novolca resins or any other kind of polymer films. The deposition is assisted by low energy ion beam exposure, like 5 KeV H$^+$ beams. Ion beams are energetic enough to generate radicals from any kind of organic compounds. For lithographic applications, however, organometallic compounds like organosilicons, organotins and other volatile organometallic compounds are preferred.

Any conventional ion beam gun can be used for carrying out the process of the invention.

## Examples

A poly(methyl methacrylate) substrate was placed inside a closed chamber containing tetravinyl silane at a pressure of 0.13 pascals ($1 \times 10^{-4}$ torr). A Magmiller ion gun obtained from Commonwealth Scientific Corp, Alexandria, Virginia, USA, 2-30 gun was used with a hydrogen pressure through the gun of 0.04 Pascals ($3 \times 10^{-5}$ torr). The exposure was conducted at 0.13 Pascals ($1 \times 10^{-4}$ torr), with the gun directed towards the substrate through a gas inlet tube. The ion beam exposure and simultaneous deposition were carried out for 30 minutes with the ion beam current of 10 to 50 A, a mounting to an ion dose of $1 \times 10^{-4}$ C/cm$^2$. This dose can be reduced significantly either by increasing the silane pressure, or by using postgrafting after the ion beam exposure.

Any kind of polymer film which can be etched away in oxygen plasma, can be used. PMMA results in positive tone patterns in wet development after ion beam exposures. Negative tone polymer patterns are obtained with dry oxygen plasma or RIE development; the deposited poly-(tetravinylsilane) film acted as a barrier layer for oxygen plasma.

Polymer patterns are developed in either oxygen plasma or oxygen RIE; in our RIE condition the oxygen pressure was 13.3. Pascals (100 micron), with 4 sccm flow, with a bias potential applied to the wafer of −250V; the etch time was 20 minutes for 2 microns thickness.

In another example, a silicon wafer served as the substrate for the deposition of a film of polystyrene. The mask used was copper grid wire laid in two levels; each level was separated at least 200 microns from the other; by slightly offsetting their positions fairly narrow lines could be defined.

Polymer styrene films with smooth surfaces were deposited in H+ beam assisted polymerisation in well defined patterns.

## Claims

1. A microlithographic process comprising depositing a pattern-exposed polymer film on a surface of a substrate by a method consisting of confining a monomer vapour in a closed chamber containing the substrate and exposing the monomer vapour to a patterned beam of ions the process being characterised by the deposited polymer film being resistant to oxygen plasma, and by the process further comprising providing an oxygen plasma to dry etch surface portions of the substrate not protected by the exposed polymer film.

2. A process as claimed in claim 1, in which the dry etching of the surface portions of the substrate with the oxygen plasma is performed in the same chamber as that in which the pattern-exposed polymer film is deposited.

3. A process as claimed in claim 1 or claim 2, in which the surface on which the pattern-exposed polymer film is deposited is that of a resist film.

4. A process as claimed in any preceding claim, in which the monomer is an organosilicon compound.

5. A process as claimed in any of claims 1 to 3, in which the monomer is a phenyl vinyl compound.

6. A process as claimed in any preceding claim, in which the ions of the beam are protons.

7. A process as claimed in any preceding claims, in which the substrate is a silicon wafer.

## Patentansprüche

1. Mikrolithographisches Verfahren, enthaltend die Abscheidung eines musterbelichteten Polymerfilms auf einer Oberfläche eines Substrats durch eine Methode, welche aus der Einschliessung eines monomeren Dampfes in einer geschlossenen Kammer besteht, welche das Substrat enthält und den monomeren Dampf einem gemusterten Ionenstrahl aussetzt; wobei das Verfahren dadurch gekennzeichnet ist, dass der abgeschiedene Polymerfilm sauerstoffplasmafest ist und dass das Verfahren ferner die Bereitstellung eines Sauerstoffplasmas zum Trocknen von Atzoberflächenteilen des Substrats enthält, welche von dem belichteten Polymerfilm nicht geschützt sind.

2. Verfahren nach Anspruch 1, in welchem das Trockenätzen der Oberflächenteile des Substrats mit dem Sauerstoffplasma in der gleichen Kammer durchgeführt wird wie die, in welcher der musterbelichtete Polymerfilm abgeschieden wird.

3. Verfahren nach Anspruch 1 oder 2, in welchem die Oberfläche, auf welcher der musterbelichtete Polymerfilm abgeschieden wird, die eines Resistfilms ist.

4. Verfahren nach einem der vorangehenden Ansprüche, in welchem das Monomer eine Organosiliziumverbindung ist.

5. Verfahren nach einem der Ansprüche 1 bis 3, in welchem das Monomer eine Phenyl-Vinyl-Verbindung ist.

6. Verfahren nach einem der vorangehenden Ansprüche, in welchem die Ionen des Strahles Protonen sind.

7. Verfahren nach einem der vorangehenden Ansprüche, in welchem das Substrat eine Siliziumscheibe ist.

## Revendications

1. Procédé de microlithographie comprenant le dépôt d'une couche polymère exposée selon un motif sur une surface d'un substrat par un procédé consistant à confiner une vapeur monomère dans une enceinte fermée contenant le substrat et à exposer la vapeur monomère à un faisceau d'ions formant une image; ce procédé étant caractérisé en ce que la couche de polymère déposée est résistante à un plasma d'oxygène, et en ce que le procédé comprend en outre l'étape consistant à prévoir un plasma d'oxygène pour graver à sec des parties superficielles du substrat non protégées par la couche de polymère exposée.

2. Procédé selon la revendication 1, dans lequel la gravure à sec des parties superficielles du substrat par un plasma d'oxygène est réalisée dans la même chambre que celle dans laquelle la couche de polymère exposée selon un motif est déposée.

3. Procédé selon la revendication 1 ou la revendication 2, dans lequel la surface sur laquelle la couche de polymère exposée à un motif est déposée est celle d'une couche de produit photosensible.

4. Procédé selon l'une quelconque des revendications précédentes dans lequel le monomère est un organosilicium.

5. Procédé selon l'une quelconque des revendications 1 à 3, dans lequel le monomère est un phényl vinyl.

6. Procédé selon l'une quelconque des revendications précédentes dans lequel les ions du faisceau sont des protons.

7. Procédé selon l'une quelconque des revendications précédentes dans lequel le substrat est une tranche de silicium.